# EUROPÄISCHE PATENTANMELDUNG

(11) **EP 0 971 054 A1**
(43) Veröffentlichungstag der Anmeldung: **12.01.2000**
(21) Anmeldenummer: 99112747.3
(22) Anmeldetag: 01.07.1999
(51) Int. Cl.: C30B 15/10, C30B 35/00

(54) **Stütztiegel zur Stützung von Schmelztiegeln**

(30) Priorität: 09.07.1998 DE 19830785
(71) Anmelder: Wacker Siltronic Gesellschaft für Halbleitermaterialien Aktiengesellschaft, 84489 Burghausen (DE)
(72) Erfinder: Löbmann, Arthur, Dr., 84547 Emmerting (DE)
(74) Vertreter: Rimböck, Karl-Heinz, Dr.

(57) **Zusammenfassung**

Die Erfindung bezieht sich auf einen Stütztiegel zur Aufnahme und Stützung von Schmelztiegeln, insbesondere von Schmelztiegeln in Kristallziehanlagen, der dadurch gekennzeichnet ist, daß die Innenseite des Stätztiegelmantels von einer krummen Oberfläche begrenzt ist

## Beschreibung

Die Erfindung bezieht sich auf einen Stütztiegel zur Stützung von Schmelztiegeln, insbesondere von Schmelztiegeln in Kristallziehanlagen.

Für die Herstellung hochreiner einkristalliner Siliciumstäbe sind das Tiegelziehverfahren nach Czochralski und das Zonenziehverfahren bekannt geworden. Beim Tiegelziehen von Kristallstäben, insbesondere von Halbleiterstäben nach Czochralski, wird in der Regel der zur Erzeugung der Schmelze vorgesehene mono- oder polykristalline Halbleiterbruch in einem Schmelztiegel vorgelegt.

Durch Beheizung wird dann die Tiegeltemperatur gesteigert, bis der Tiegelinhalt nach und nach in den geschmolzenen Zustand übergeht. An die Schmelze wird schließlich ein Impfkristall angesetzt, und im allgemeinen, unter Drehung von Tiegel und Kristall, ein einkristalliner Kristallstab aus der Schmelze gezogen.

Der aus Quarzglas gefertigte Schmelztiegel wird bei der Schmelztemperatur von Halbleiterbruch plastisch, und bedarf der Stützung durch einen äußeren Stütztiegel.

Stütztiegel dieser Gattung sind bei den herrschenden Temperaturverhältnissen idealerweise formstabil, verhalten sich chemisch inert und werden beispielsweise aus Reinstgraphit, CFC (Carbon Fiber reinforced Carbon) oder CCC (Carbon Carbon Compound) gefertigt. Bei Temperaturänderungen zieht sich der Quarzglastiegel zusammen bzw. dehnt sich aus, so daß der Stütztiegel vorzugsweise ein- oder mehrteilig ausgeführt ist, und/oder über Einschnitte, Fugen oder Schlitze verfügt, um die Bewegungen des Quarzglastiegels auszugleichen.

Insbesondere während der Abkühlphase nach dem Ziehprozeß kommt es zu einer Ausdehnung des Quarzglastiegels, so daß dieser großflächig und formschlüssig an der, gemäß dem Stand der Technik, radialsymmetrischen Innenseite des Stütztiegelmantels anliegt.

Nach dem Ziehprozeß muß der erkaltete Quarzglastiegel, der noch verunreinigte Restschmelze enthält, aus dem Stütztiegel mittels Ausbauwerkzeug, wie beispielsweise eines Hammers, ausgebaut werden. Da in einer Czochralski-Tiegelziehanlage hochreine Siliciumstäbe gezogen werden, trägt jegliches Werkzeug, das in der Anlage verwendet wird, Kontaminationen ein.

Aufgabe der Erfindung war es daher, einen Stütztiegel zur Stützung von Schmelztiegeln bereitzustellen, aus dem die Schmelztiegel nach dem Abkühlen ohne Zuhilfenahme von Werkzeugen ausgebaut werden können.

Gelöst wird die Aufgabe durch einen ein- oder mehrteiligen Stütztiegel zur Stützung von Schmelztiegeln, dadurch gekennzeichnet, daß die Innenseite des Stütztiegelmantels von einer krummen Oberfläche begrenzt ist, wobei eine zylindrische Oberfläche ausgenommen ist.

Die Erfindung zeichnet sich dadurch aus, daß der Ausbau des erkalteten Quarzglastiegel einfach durchzuführen ist, und keinerlei Ausbauwerkzeug verwendet werden muß, insbesondere dann, wenn die Innenseite des Stütztiegelmantels von einer krummen Oberfläche, ausgewählt aus der Gruppe der Kegelstumpfe, der Rotationsparaboloide oder der Rotationshyperboloide begrenzt ist.

Vielmehr rutscht der Quarzglastiegel, mitsamt der erstarrten Restschmelze, selbständig nach dem Umdrehen der Schmelzvorrichtung um 180° aus dem erfindungsgemäßen Stütztiegel. Quarzglastiegel und Restschmelze können damit ohne der Gefahr einer von außen eingetragenen Kontamination aus der Tiegelziehanlage entfernt werden.

Auch Quarzglastiegel mit der erfindungsgemäßen Formgebung ihrer Außenseite können ohne kontaminierende Hilfsmittel aus Stütztiegeln gemäß dem Stand der Technik ausgebaut werden.

Erfindungsgemäße Stütztiegel sind vorzugsweise aus Reinstgraphit, CFC oder CCC gefertigt. Um Bewegungen des Quarzglastiegels bei Temperaturänderungen auszugleichen ist die erfindungsgemäße Stütztiegelgattung mit mindestens einem Einschnitt, einer Fuge und/oder eines Schlitzes versehen, der oder die, radialsymmetrisch oder radialasymmetrisch, parallel oder antiparallel senkrecht oder schräg in Richtung Tiegelbodenebene verlaufen. Form, Größe und Anzahl der Einschnitte, Fugen und/oder Schlitze ist der jeweiligen Stütztiegelgröße anzupassen.

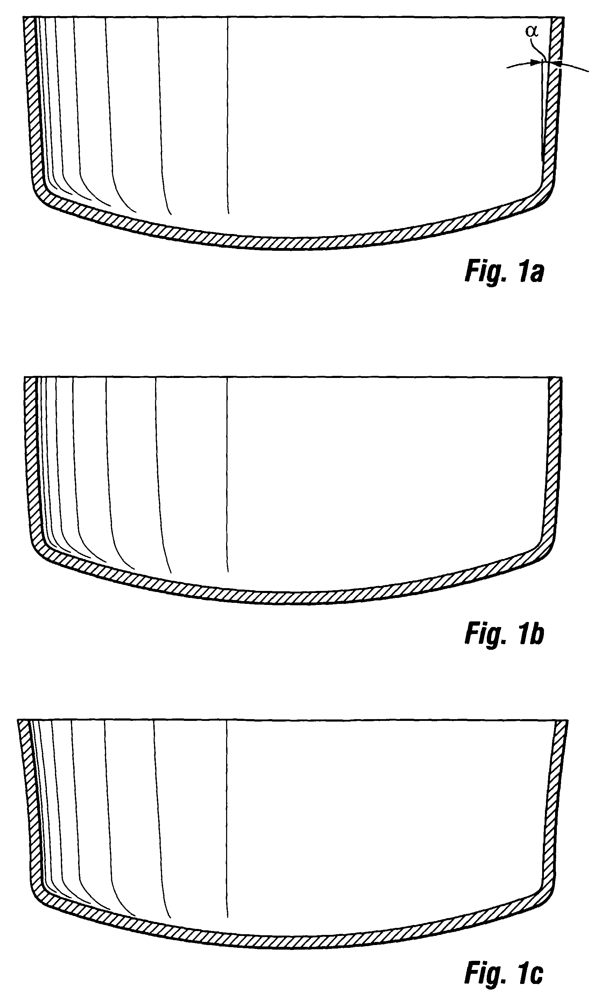

Die Figuren 1a bis c zeigen drei mögliche Ausführungsformen der erfindungsgemäßen Stütztiegelgattung im Vertikalschnitt; eine konische (1a), eine paraboloide (1b) und eine hyperboloide Form (1c) wobei der Winkel α in Fig. 1a die Abweichung von der Senkrechten bezeichnet, und bevorzugt zwischen 1 und 30°, besonders bevorzugt zwischen 1 und 5° beträgt.

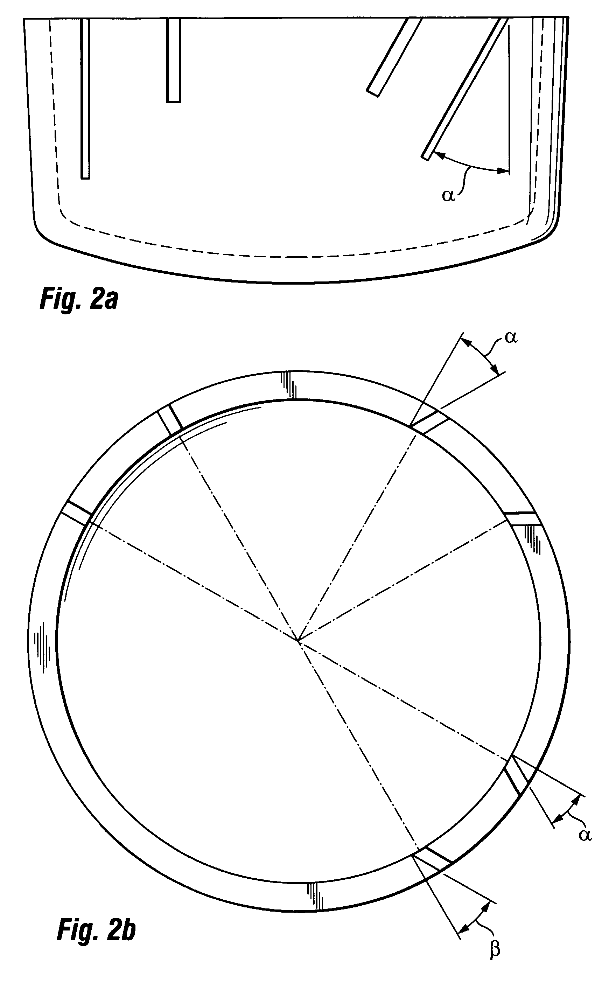

Die Figuren 2a und 2b zeigen die erfindungsgemäße Stütztiegelgattung in Seitenansicht und in der Draufsicht. In Fig. 2a ist die Richtung der Einschnitte, Fugen und/oder Schlitze bezüglich der Tiegelbodenebene dargestellt, die senkrecht und/oder schräg verlaufen können. Der Winkel α beträgt bevorzugt zwischen 1 und 45° und besonders bevorzugt zwischen 10 und 40°. In Fig. 2b sind die Anordnung der Einschnitte, Fugen und/oder Schlitze bezüglich des Tiegelbodenebene dargestellt, die radialsymmetrisch oder radialasymmetrisch, parallel und/oder antiparallel angeordnet sein können. Der Winkel α und β beträgt bevorzugt zwischen 1 und 45° und besonders bevorzugt zwischen 10 und 40°.

## Patentansprüche

1. Ein- oder mehrteiliger Stütztiegel zur Stützung von Schmelztiegeln, dadurch gekennzeichnet, daß die Innenseite des Stütztiegelmantels von einer krummen Oberfläche begrenzt ist, wobei eine zylindrische Oberfläche ausgenommen ist.

2. Stütztiegel gemäß Anspruch 1, dadurch gekennzeichnet, daß die Innenseite des Stütztiegelmantels von einer krummen Oberfläche, ausgewählt aus der Gruppe der Kegelstumpfe, der Rotationsparaboloide oder der Rotationshyperboloide begrenzt ist.

3. Stütztiegel nach Anspruch 1 oder 2, gekennzeichnet durch mindestens einen Einschnitt, eine Fuge und/oder einen Schlitz im Stütztiegelmantel, welcher senkrecht oder schräg in Richtung Tiegelbodenebene verläuft.

4. Stütztiegel nach einem der Ansprüche 1 bis 3, dadurch gekennzeichnet, daß mindestens ein Einschnitt, eine Fuge und/oder ein Schlitz radialsymmetrisch oder radialasymmetrisch, parallel oder antiparallel in Richtung Tiegelbodenebene verläuft.

5. Verwendung von Stütztiegeln mit einem oder mehreren der Kennzeichen der Ansprüche 1 bis 4 zum Stützen von Schmelztiegeln.
